# EUROPÄISCHE PATENTSCHRIFT

(11) **EP 1 982 355 B1**
(45) Veröffentlichungstag und Bekanntmachung des Hinweises auf die Patenterteilung: **19.07.2017**
(21) Anmeldenummer: 07711484.1
(22) Anmeldetag: 09.02.2007
(51) Int. Cl.: H01L 25/07, H01L 23/473

(54) **LEISTUNGSELEKTRONIKANORDNUNG**
POWER ELECTRONICS ASSEMBLY
DISPOSITIF ÉLECTRONIQUE DE PUISSANCE

(30) Priorität: 10.02.2006 DE 102006006175
(43) Veröffentlichungstag der Anmeldung: 22.10.2008
(73) Patentinhaber: ECPE Engineering Center for Power Electronics GmbH, 90443 Nürnberg (DE)
(72) Erfinder: MÄRZ, Martin, 90491 Nürnberg (DE); SCHIMANEK, Ernst, 90491 Nürnberg (DE); BRUNNER, Dieter, 95448 Bayreuth (DE); SCHLETZ, Andreas, 92694 Etzenricht (DE)
(74) Vertreter: Zinsinger, Norbert
(86) Internationale Anmeldenummer: PCT/EP2007/001115
(87) Internationale Veröffentlichungsnummer: WO 2007/090664

(56) Entgegenhaltungen:
- EP-A- 1 124 259
- EP-A1- 1 416 534
- US-A- 5 455 458
- US-A- 6 154 369

## Beschreibung

Die Erfindung betrifft eine Leistungselektronikanordnung, die mit einem Isoliersubstrat, mit einem unterhalb des Isoliersubstrats angeordneten Kühlelement und mit mindestens einem Leistungselektronikbauelement versehen ist, das auf einer Seite des Isoliersubstrats gegenüber dem Kühlelement auf einer Metallisierungsfläche des Isoliersubstrats angebracht ist.

Eine derartige Anordnung ist aus DE 33 36 979 A1 bekannt. Das dort beschriebene Tyristormodul weist ein isolierendes Substrat aus Aluminiumoxid auf, das beidseitig mit einer Metallisierungsschicht versehen ist. Die oben liegende Metallisierungsschicht ist schaltungsgerecht strukturiert und ist über eine Lötverbindung mit Elektrodenplatten eines Tyristorchips und eines Diodenchips verbunden. Die gegenüberliegende, unterseitige Metallisierungsschicht ist über eine Lötverbindung mit einem Kühlkörper bestehend aus einer Metallplatte verbunden.

Eine derartige Halbleiteranordnung wird weiter auch von DE 36 43 288 C2 beschrieben. Das dort beschriebene Halbleiterbauelement in Modulbauweise weist ein Modulplättchen mit einer beidseitig mit Metallisierungen versehenen Isolierplatte auf, die auf einem als Trägerkörper dienenden Kühlkörper angeordnet ist. Auf der dem Kühlkörper gegenüberliegenden Seite der Isolierplatte sind Halbleiterelemente, bspw. Dioden, Transistoren und Tyristoren, aber auch Widerstände und/oder Kapazitäten auf Halbleiterbasis angeordnet. Der Kühlkörper ist als plattenförmiger oder blockförmiger Kühlkörper ausgebildet, der auch eine Fremdkühlung aufweisen kann.

Weiter ist es bekannt eine Fremdkühlung eines Kühlkörpers für eine Halbleiteranordnung dadurch zu realisieren, dass der Kühlkörper von einem Kühlmedium durchströmt wird und auf diese Weise die Leistungselektronik über den Schichtenaufbau gekühlt wird. Eine weitere Leistungselektronikanordnung ist aus US5455458 bekannt. Nachteilig an den derzeitig bekannten Lösungen für direkt gekühlte Elektronikleistungsmodule ist die relativ große Anzahl von Schichten, aufgebaut aus Materialien mit unterschiedlichen thermischen Ausdehnungskoeffizienten. Die Halbleiterelemente sind auf einer Metalllage angebracht, die wiederum auf einem Isolierstoffsubstrat angebracht ist, das über eine weitere aufkaschierte Metalllage und ein Lot mit einer von einem Kühlmedium angeströmten metallischen Grundplatte verbunden ist. Dies hat eine verminderte Zyklenfestigkeit und damit verminderte Lebensdauer zur Folge.

Der Erfindung liegt so die Aufgabe zugrunde, einen verbesserten Aufbau einer direkt gekühlten Halbleiteranordnung anzugeben.

Diese Aufgabe wird von einer Leistungselektronikanordnung nach Anspruch 1 gelöst. Durch die erfindungsgemäße Lösung wird eine höhere Zyklenfestigkeit, eine Vereinfachung der Abdichtung sowie eine kompaktere Bauweise erreicht. Gemäß eines bevorzugten Ausführungsbeispiels der Erfindung weist die Leistungselektronikanordnung eine die Metallkrempe überlappenden, umlaufenden Klemmrahmen auf und die Metallkrempe ist zwischen dem Klemmrahmen und dem Kühlelement eingespannt.

Die Metallkrempe wird mittels des Klemmrahmens gegen das Kühlelement gepresst, wodurch gleichzeitig eine kraftschlüßige Verbindung und Abdichtung bewirkt wird. Hierdurch wird eine direkte Anströmung der Unterseite des Isoliersubstrats mittels des Kühlmediums bei erhöhter Zyklenfestigkeit möglich. Würde das Isoliersubstrat direkt zwischen Klemmrahmen und Kühlelement eingespannt, so müsste zusätzlich zur mechanischen Befestigung des Moduls die Anpresskraft für die nötige Abdichtung auf das Isoliersubstrat über eine Dichtung aufgebracht werden, was zum einen zu einer erhöhten Bruchgefahr bei der Montage als auch zu einer verminderten Zyklenfestigkeit führen würde. Die Verbindung zwischen einem Isoliersubstrat und einem (metallischen) Kühler besitzt eine hohe Haftreibung aufgrund der oxidierten Oberfläche des Kühlers, was zu thermischem Stress und zum Bruch des Isoliersubstrats führt. Diese Nachteile werden bei dieser erfindungsgemäßen Lösung vermieden.

Anstelle einer kraftschlüßigen Verbindung zwischen Kühlelement und Metallkrempe ist es auch möglich, das Kühlelement und die Metallkrempe stoffschlüßig zu verbinden. So kann die Metallkrempe mit dem Kühlelement über eine umlaufende Schweißnaht verbunden sein, die gleichzeitig eine formschlüßige Verbindung und Abdichtung bewirkt. Weiter ist es möglich, daß die Krempe in das Kühlelement beispielsweise durch Laserschweißen eingeschweißt ist oder daß die Metallkrempe mit dem Kühlelement durch Löten oder Kleben verbunden ist.

Als Isoliersubstrat wird bevorzugt ein plattenförmiges Keramiksubstrat verwendet. Ein Keramiksubstrat besitzt einen niedrigeren thermischen Übergangswiderstand als ein Kunststoffsubstrat. Durch die Erfindung wird eine erhöhte Zyklenfestigkeit auch beim Einsatz eines Keramiksubstrats erzielt, dessen Einsatz an sich aufgrund seiner Oberflächenbeschaffenheit und seiner Bruchneigung (relativ spröde) besonders kritisch ist.

Die die Metallkrempe ausbildende Metalllage besitzt vorzugsweise eine Dicke von 0,1 mm bis 5 mm, insbesondere eine Dicke von 0,1 mm bis 2 mm.

Gemäß einer bevorzugten Ausführungsform der Erfindung ist die die Metallkrempe ausbildende Metalllage auf der dem Kühlelement gegenüberliegenden Oberfläche des Isoliersubstrats angebracht. Hierbei ist es zweckmäßig die Metalllage derart zu strukturieren, dass die von der Metalllage gebildeten Metallisierungsflächen, auf denen Leistungselektronikbauelemente angeordnet sind oder die galvanisch mit Leistungselektronikbauelementen verbunden sind, von dem die Metallkrempe bildenden Bereich der Metalllage durch entsprechende Unterbrechungen der Metalllage elektrisch isoliert sind.

Weiter ist es auch möglich, dass die die Metallkrempe ausbildende Metalllage auf der dem Kühlelemente zugewandten Fläche des Isoliersubstrats angebracht ist.

Das Isoliersubstrat ist auf seiner dem Kühlelement zugewandten Seite vorzugsweise geeignet strukturiert, um einen niedrigen thermischen Widerstand zum Kühlmedium zu erreichen.

Gemäß einer bevorzugten Ausführungsform der Erfindung überlappt der umlaufende Klemmrahmen mit dem Isoliersubstrat. Hierdurch wird ein Brechen des Isoliersubstrats bei Überdruck des Kühlmediums verhindert. Weiter ist von Vorteil, wenn der Klemmrahmen mit Stegen versehen ist, welche das Isoliersubstrat nicht nur am Rand gegen Überdruck fixieren. Dies ist insbesondere bei der Verwendung von großflächigeren Keramikplatten als Isoliersubstrat von Vorteil.

Weiter kann vorgesehen sein, dass das Isoliersubstrat über ein oder mehrere Abstandhalter auf dem Kühlelement aufsitzt. Bei einem Unterdruck des Kühlmediums wird so ein Brechen des Isoliersubstrats verhindert.

Weitere Vorteile ergeben sich dadurch, dass in der Metallkrempe ein Faltenbalg und/oder eine Sicke eingeformt sind. Der Faltenbalg bzw. die Sicke ist hierbei bevorzugt zwischen dem Isoliersubstrat und dem Bereich der Metallkrempe in die Metallkrempe eingeformt, indem die Metallkrempe zwischen die Dichtflächen des Klemmrahmens und des Kühlelements eingespannt ist. Durch die Sicke bzw. den Faltenbalg werden thermisch/mechanische Spannungen, die durch die unterschiedlichen Ausdehnungskoeffizienten der verwendeten Materialien oder durch Überdruck und Unterdruck des Kühlmediums verursacht werden, abgefedert. Einem Bruch des Isoliersubstrats wird dadurch vorgebeugt. Weiter wird die Kerbwirkung zwischen Metallkrempe und Isoliersubstrat minimiert und so ein vorzeitiges Ablösen der Krempe von dem Isoliersubstrat verhindert.

Gemäß eines weiteren bevorzugten Ausführungsbeispiels der Erfindung weist der Klemmrahmen und/oder das Kühlelement im Bereich der Dichtflächen Dichtschneiden auf. Die Dichtschneiden verformen bei der Montage nach dem Eindringen in die Metallkrempe diese elastisch und plastisch wodurch eine hervorragende Abdichtung erzielt wird.

Im Folgenden wir die Erfindung anhand von mehreren Ausführungsbeispielen unter Zuhilfenahme der beiliegenden Zeichnungen beispielhaft erläutert.
Fig. 1 zeigt eine Schnittdarstellung einer erfindungsgemäßen Halbleiteranordnung gemäß eines ersten Ausführungsbeispiels der Erfindung.
Fig. 2 zeigt eine erfindungsgemäße Halbleiteranordnung gemäß einem weiteren Ausführungsbeispiel der Erfindung.
Fig. 3a zeigt eine Teilansicht der Leistungselektronikanordung nach Fig. 2.
Fig. 3b zeigt eine Teilansicht einer erfindungsgemäßen Leistungselektronikanordnung gemäß eines weiteren Ausführungsbeispiels der Erfindung.

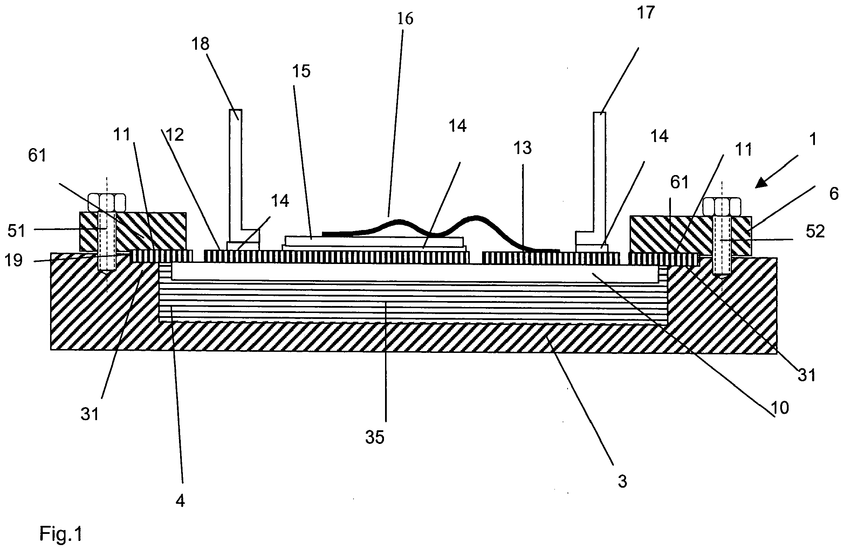

Fig. 1 zeigt eine Leistungselektronikanordnung 1 mit einem Kühlelement 3, einem Klemmrahmen 6 und einem Isoliersubstrat 10.

Bei dem Isoliersubstrat 10 handelt es sich um ein plattenförmiges Keramiksubstrat, dessen Dicke größer als 0,1 Millimeter ist. Bevorzugt weist das Isoliersubstrat eine Dicke von 0,2 bis 4 Millimeter auf. Die Isolierkeramik besteht vorzugsweise aus Aluminiumoxid, Aluminiumnitrid, Bornitrid oder Siliziumnitrid. Weiter ist es auch möglich dass das Isoliersubstrat 10 aus einem Kunststoff oder aus einem mit Keramik gefüllten Kunststoff besteht.

Das Isoliersubstrat 10 ist auf seiner Oberseite mit einer Metalllage 19 versehen, die auf das Isoliersubstrat gebondet oder hart-, weich- oder aktivgelötet oder kaschiert ist. Die Metalllage 19 bildet auf dem Isoliersubstrat 10 mehrere Metallisierungsflächen aus, von denen in Fig. 1 zwei Metallisierungsflächen 12 und 13 gezeigt sind. Auf diesen Metallisierungsflächen sind Leistungselektronikbauelemente wie Tyristoren, Dioden und Transistoren angeordnet. So zeigt Fig. 1 einen Transistorchip 15, der über eine unterseitige Metallisierungsfläche mittels eines Lots 14 mit der Metallfläche 12 verbunden ist. Weiter ist es möglich, dass auf den Metallisierungsflächen auch passive Bauelemente wie Widerstände und Kondensatoren und/oder Stromanschlusselemente angebracht sind. So ist die Metallisierungsfläche 13 über ein Lot 14 mit dem Stromanschlusselement 17 und die Metallisierungsfläche 12 über ein Lot 14 mit dem Stromanschlusselement 18 verbunden. Der Transistorchip 15 ist wiederum über einem Bond-Draht 16 mit der Metallisierungsfläche 13 verbunden.

Die Metalllage 19 ist hierbei auf dem Isoliersubstrat so aufgebracht, dass sie über das Isoliersubstrat übersteht. Wie in Fig. 1 dargestellt bildet der das Isoliersubstrat 10 überragende Bereich der Metalllage 19 eine das Isoliersubstrat allseitig umrandende Metallkrempe 11 aus. Die Metalllage 19 ist hierbei so strukturiert, dass die Metallkrempe 11 von der eigentlichen Schaltung elektrisch isoliert ist. Es ist jedoch auch möglich, dass die Metallkrempe mit Masseflächen bildenden Metallisierungsflächen verbunden ist.

Die Metalllage 19 besteht vorzugsweise aus Kupfer oder einer Kupferlegierung. Weiter ist es auch möglich, dass die Metalllage aus Aluminium oder aus einer Legierung basierend auf Kupfer, Nickel und/oder Aluminium besteht. Die Metalllage hat eine Dicke von 0,1 bis 5 Millimeter, vorzugsweise eine Dicke von 0,3 ist 2 Millimeter.

Das von dem Isoliersubstrat 10, der Metalllage 19 und den auf der Metalllage 19 aufgebrachten elektrischen Bauelementen gebildete Leistungselektronikmodul wird bei der Montage auf das Kühlelement 3 aufgesetzt. Das Kühlelement 3 weist auf seiner dem Isoliersubstrat 10 zugewandten Seite unterhalb des Isoliersubstrats 10 eine Ausnehmung auf, die von dem Leistungselektronikmodul abgedeckt wird. Weiter weist das Kühlelement 3 in den Bereichen, in denen die Metallkrempe 11 aufliegt, eine umlaufende Dichtfläche 31 auf, welche den Isolierstoffkörper 10 vollständig umrandet.

Unterhalb des Isoliersubstrats 10 wird so eine von dem Isoliersubstrat 10 und den Randflächen der Ausnehmung begrenzter Hohlraum 35 ausgebildet, der nach der Montage mit einem flüssigen Kühlmedium 4 befüllt bzw. von einem Kühlmedium durchströmt wird.

Bei dem Kühlelement 3 handelt es sich bevorzugt um einen Aluminium- oder Stahlkörper, welcher über entsprechende Zu- und Abführungen für das Kühlmedium verfügt. Weiter ist es auch möglich, daß das Kühlelement aus Kupfer, Messing, einer Aluminium- oder Kupferlegierung, Keramik oder Kunststoff besteht. Weiter ist es auch möglich, dass in dem Kühlelement 3 im Bereich des Isoliersubstrats 10 zwei oder mehr Ausnehmungen eingeformt sind, welche bspw. durch Stege oder Abstandshalter zur Auflage des Isoliersubstrats 10 strukturiert sind.

Gemäß einer weiteren Ausführungsform der Erfindung ist das Kühlelement 3 zur Kühlung von zwei oder mehr Elektronikleistungsmodulen ausgeformt.

Der Klemmrahmen 6 besteht aus einem Metallrahmen, welcher die Metallkrempe 19 allseitig überlappt. Dieser Rahmen weist an seiner Unterseite im Bereich der Metallkrempe 11 eine umlaufende Dichtfläche 61 auf. Um eine sichere mechanische Fixierung des Leistungselektronikmoduls gegenüber dem Kühlelement 3 zu erreichen und ein Ablösen der Metallkrempe 11 von dem Isoliersubstrat 10 zu vermeiden, überlappt der Klemmrahmen 6 die Randbereiche des Isoliersubstrats 10. Es ist jedoch auch möglich, dass der Klemmrahmen 6 die Randbereiche des Isoliersubstrats 10 nicht überdeckt.

Weiter ist auch möglich, dass der Klemmrahmen 6 über einen oder mehrere Stege verfügt, welche sich ausgehend von den Randbereichen des Isoliersubstrats 10 in zentrale Bereiche des Isoliersubstrats 10 erstrecken und eine direkte Krafteinleitung des von dem Kühlmedium ausgeübten Drucks in den Klemmrahmen ermöglichen und so die mechanische Belastung des Isoliersubstrats 10 verringern. Vorzugsweise setzen diese Stege hierbei auf hierfür vorgesehenen Bereiche der Metalllage auf, welche von der eigentlichen Elektronik des Leistungselektronikmoduls isoliert sind.

Weiter ist es auch möglich, daß ein Stützrahmen vorgesehen ist, der auf dem Klemmrahmen 6 oder dem Kühlelement 3 fixiert ist und ebenfalls, wie oben beschrieben, die mechanische Belastung des Isoliersubstrats 10 verringert. Dieser Stützrahmen kann beispielsweise aus glasfaserverstärktem Kunststoff gefertigt sein. Weiter ist es auch möglich, dass der Stützrahmen zugleich einen Halterahmen für die Ansteuerelektronik bildet.

Der Klemmrahmen 6 ist über mehrere Spannschrauben, von denen in Fig. 1 zwei Spannschrauben 51 und 52 gezeigt sind, mit dem Kühlelement 3 verschraubt. Die Metallkrempe 11 wird beim Verschrauben des Klemmrahmens 6 mit dem Kühlelement 3 im Bereich der umlaufenden Dichtflächen 61 und 31 gegen das Kühlelement gepresst, wodurch eine kraftschlüssige Verbindung zwischen dem Leistungselektronikmodul und dem Kühlelement und gleichzeitig auch eine Abdichtung des für die Aufnahme des flüssigen Kühlmediums vorgesehenen Hohlraums 35 erfolgt. In das Kühlelement 3 oder den Klemmrahmen 6 ist hierzu eine umlaufende Nut abgeformt, welche der Aufnahme der Randbereiche der Metallkrempe 11 dient und deren Tiefe bspw. zur Erzielung einer Übermaßpassung auf die Dicke der Metalllage 19 abgestimmt ist.

Weiter ist es möglich, daß zwischen der Metallkrempe und den Dichtflächen des Kühlelements eine umlaufende Kleber- oder Dichtmittelschicht oder ein Dichtring vorgesehen wird.

Weiter ist es auch möglich, dass die Metalllage 19 das Isoliersubstrat 10 nicht wie in Fig. 1 gezeigt allseitig überragt, sondern vielmehr auf der Unterseite des Isoliersubstrats 10 eine das Isoliersubstrat allseitig überragende Metalllage vorgesehen ist. Diese Metalllage bildet in gleicher Weise wie die Metalllage 19 nach Fig. 1 eine das Isoliersubstrat allseitig umrandende Metallkrempe aus. Diese untere Metalllage kann hierbei strukturiert sein und beispielsweise nur in den Randbereichen des Isoliersubstrats 10 vorgesehen sein. Es ist jedoch auch möglich, dass die untere Metalllage das Isoliersubstrat vollflächig bedeckt, um so beispielsweise eine besonders gute Haftung zwischen der Metalllage und dem Isoliersubstrat 10 zu erzielen oder eine zusätzliche Feuchtigkeitssperrschicht zwischen dem Isoliersubstrat 10 und dem Kühlmittel 4 auszubilden. Die untere Metalllage ist hierbei wie die Metalllage 19 ausgestaltet, sie besteht somit bevorzugt aus einer dünnen Kupfer- oder Aluminiumschicht einer Dicke von 0,1 mm bis 2 mm.

Die von der unteren Metalllage ausgebildete Metallkrempe wird nun in analoger Weise, wie in Fig. 1 gezeigt, zwischen dem Klemmrahmen und dem Kühlelement eingespannt, wodurch gleichzeitig eine kraftschlüssiges Verbindung und eine Abdichtung des Hohlraums 35 bewirkt wird. Hierbei ist es vorteilhaft, den Klemmrahmen 6 entsprechend auszuformen, so dass nach der Montage der Randbereich des Isoliersubstrats möglichst vollflächig auf dem Klemmrahmen aufliegt und so der von dem Kühlmedium ausgeübte Anpressdruck von dem Klemmrahmen aufgenommen wird. Hierzu ist beispielsweise in die Unterseite des Klemmrahmens eine entsprechende umlaufende Nut eingebracht, deren Tiefe der Dicke des Isoliersubstrats 10 entspricht.

Weiter ist es auch möglich, auf einer auf der Unterseite des Isoliersubstrats 10 vorgesehenen Metalllage Strukturen aus einem wärmeleitfähigen Material zur Vergrößerung der Oberfläche und somit zur Verringerung des thermischen Übergangswiderstandes aufzubringen. So werden beispielsweise auf einer derartigen Rückseiten-Metallisierung Formteile aus einem Kupferblech aufgelötet. Vorteilhafterweise werden die aufgebrachten Strukturen so gewählt, daß sie über eine geringe laterale Steifigkeit verfügen und so keine negativen Auswirkungen auf die Lastwechselfestigkeit besitzen.

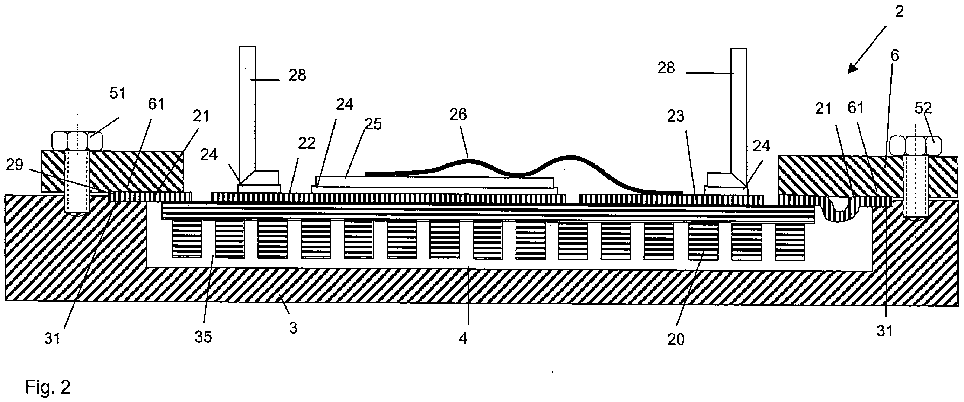

Fig. 2 zeigt eine Leistungselektronikanordnung 2, die gemäß eines weiteren Ausführungsbeispiels der Erfindung aufgebaut ist. Fig. 2 zeigt im Einzelnen ein Leistungselektronikmodul mit einem Isoliersubstrat 20, eine Metalllage 29, einem Leistungselektronikbauelement 25 und Stromanschlusselemente 28. Das Isoliersubstrat 20 ist auf seiner Unterseite geeignet strukturiert, um einen niedrigen thermischen Übergangswiderstand zum Kühlmedium zu erreichen. Wie in Fig. 2 dargestellt sind in die Unterseite des Isoliersubstrats 20 Nuten abgeformt, welche die rückseitige Oberfläche des Isoliersubstrats vergrößern und so den thermischen Übergangswiderstand verringern.

Die Metalllage 29 weist Metallisierungsflächen 22 und 23 auf, auf welchen elektrische Bauelemente befestigt sind. So ist das Leistungselektronikbauelement 25 über eine Lötverbindung, d.h. über ein Lot 24, mit der Metallisierungsfläche 22 verbunden und die Stromanschlusselemente 28 über jeweilige Lötverbindungen mit den Metallisierungsflächen 22 bzw. 23 verbunden. Das Leistungselektronikbauelement 25 ist weiter über einem Bond-Draht 26 mit der Metallisierungsfläche 23 verbunden.

Die Metalllage 29 überragt auch hier das Isoliersubstrat 20 allseitig und bildet in dem das Isoliersubstrat 20 überragenden Bereich eine das Isoliersubstrat 20 allseitig umrandende Metallkrempe 21 aus.

Die Leistungselektronikanordnung weist weiter den bereits anhand von Fig. 1 erläuterten Klemmrahmen 6 und das bereits anhand von Fig. 1 erläuterte Kühlelement 3 auf, wobei die Metallkrempe 21 in ihrem Randbereichen zwischen dem Kühlelement 3 und dem Klemmrahmen 6 mittels Spannschrauben 51 und 52 eingespannt ist. Weiter ist es auch möglich, anstelle der Spannschrauben 51 und 52 Nieten oder Schrauben mit Federringen zu verwenden.

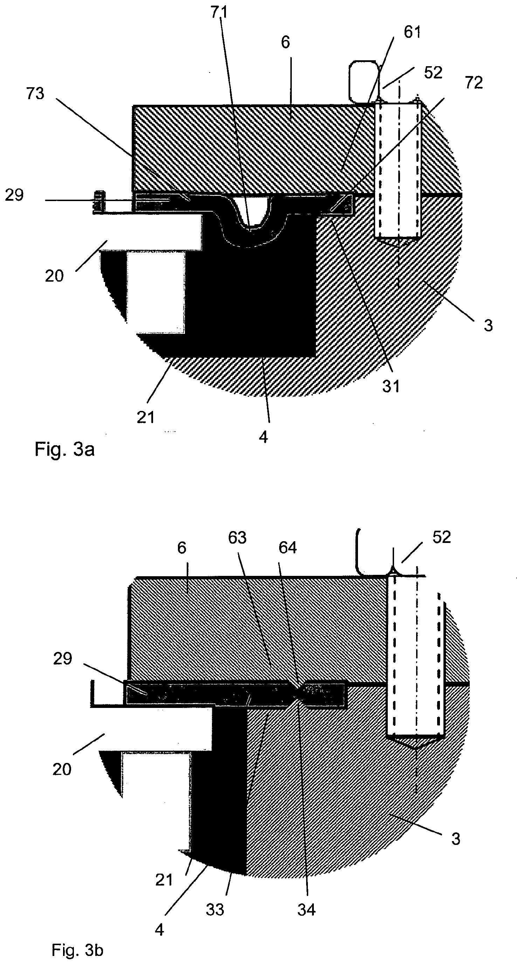

In einem ersten Bereich ist die Metallkrempe hierbei in analoger Weise wie in dem Ausführungsbeispiel nach Fig. 1 zwischen der unteren in dem Kühlelement abgeformten Dichtfläche 31 und der Dichtfläche 61 des Klemmrahmens eingespannt, wodurch gleichzeitig eine kraftschlüssige Verbindung und eine Abdichtung bewirkt wird. In einem zweiten Bereich ist zusätzlich in die Metallkrempe eine Sicke oder auch ein Faltenbalg abgeformt. Die Sicke bzw. der Faltenbalg ist hierbei in den zwischen dem Substrat 20 und den Dichtflächen 31 bzw. 61 des Kühlelements 3 bzw. des Klemmrahmens 6 liegenden Abschnitt der Metallkrempe 21 abgeformt. Dies ist im Detail in Fig. 3a gezeigt.

Fig. 3a zeigt eine Sicke 71, die in die Metalllage 29 zwischen einem ersten Bereich 73 der Metalllage 29, in dem die Metalllage 29 auf dem Isoliersubstrat 20 angebracht ist, und einem zweiten Bereich 72 der Metalllage 29, in dem die Metallkrempe 21 zwischen den Dichtflächen 61 und 31 des Klemmrahmens 6 bzw. des Kühlelements 3 eingespannt ist, eingeformt ist.

Hierbei ist es möglich, dass die Sicke 71, wie oben erläutert, nur in einem Teilbereich der Metallkrempe 21 abgeformt ist, bspw. entlang einer Längs- oder Querkante des Isoliersubstrats 20 in der die Metallkrempe 21 abgeformt ist. Es ist jedoch auch möglich, dass eine umlaufende Sicke bzw. ein umlaufender Faltenbalg in die Metallkrempe 21 abgeformt ist, der das Isoliersubstrat 20 allseitig umrandet.

Gemäß eines weiteren Ausführungsbeispiels der Erfindung sind im Bereich der Dichtflächen eine oder mehrere Dichtschneiden im Klemmrahmen und/oder in dem Kühlelement vorgesehen. Dies wird nun beispielhaft anhand von Fig. 3b erläutert.

Fig. 3b zeigt den Klemmrahmen 6, das Kühlelement 3, das Isoliersubstrat 20, die Metalllage 29 und die Klemmschraube 52. Der Klemmrahmen 6 weist eine Dichtfläche 63 mit einer Dichtschneide 64 auf. Ebenso weist das Kühlelement 3 eine Dichtfläche 33 mit einer Dichtschneide 34 auf. Die Dichtschneiden 64 und 34 sind gegenüberliegend angeordnet und verformen die Metallkrempe 21 bei der Montage wie in Fig. 3b gezeigt plastisch und elastisch, wodurch eine Abdichtung des Hohlraums 35 erzielt wird.

## Patentansprüche

1. Leistungsefefttronikanardnung (1,2) mit einem Isoliersubstrat (10, 20), das mit einer oder mehreren Metallisierungsflächen (12, 13; 22, 23) versehen ist, mit einem unterhalb des Isoliersubstrats (10, 20) angeordnetem Kühlelement (3) und mit einem oder mehreren Leistungselektronikbauelementen (15, 25), die auf einer Seite des Isoliersubstrats (10, 20) gegenüber dem Kühlelement (3) auf jeweiligen Metallisierungsflächen (12, 22) angebracht sind, wobei auf der dem Kühlelement gegenüber liegenden oder der dem Kühlelement zugewandten Oberfläche des Isoliersubstrats (10, 20) eine Metalllage (19, 29) angebracht ist, die das Isoliersubstrat (10, 20) allseitig überragt, wobei der das Isoliersubstrat (10, 20) überragende Bereich der Metalliage (19, 29) eine das Isoliersubstrat (10, 20) umrandende Metallkrempe (11, 21) ausbildet, dass das Kühlelement (3) auf seiner dem Isoliersubstrat (10, 20) zugewandten Seite unterhalb des Isoliersubstrats (10, 20) eine oder mehrere Ausnehmungen aufweist und unterhalb des Isoliersubstrats (10, 20) ein von dem Isoliersubstrat (10, 20) und von Wandflächen der einen oder mehreren Ausnehmungen begrenzter Hohlraum (35) zur Aufnahme eines flüssigen Kühlmediums (4) ausgebildet ist, und daß die Metallkrempe (11, 21) mit dem Kühlelement (3) verbunden ist,
**dadurch gekennzeichnet, dass**
- die Metalllage (19, 29) 0.1 - 2mm dick ist,
- das Isoliersubstrat (10, 20) ein Keramiksubstrat ist und
- die Metalllage (19, 29) auf das Isoliersubstrat (10, 20) aktivgelötet ist.

2. Leistungselektronikanordnung nach Anspruch 1,
**dadurch gekennzeichnet,**
**dass** die Leistungselektronikanordnung (1, 2) einen die Metallkrempe (11, 21) überlappenden, umlaufenden Klemmrahmen (6) aufweist und dass die Metallkrempe (11, 21) zwischen dem Klemmrahmen (6) und dem Kühlelement (3) eingespannt ist und dadurch mit dem Kühlelement (3) verbunden ist.

3. Leistungselektronikanordnung nach Anspruch 1,
**dadurch gekennzeichnet,**
**dass** die Metallkrempe (11, 21) mit dem Kühlelement (3) stoffschlüßig, insbesondere durch Schweißen oder Löten, verbunden ist.

4. Leistungselektronikanordnung (1, 2) nach einem der vorgehenden Ansprüche,
**dadurch gekennzeichnet,**
**dass** die die Metallkrempe (11, 21) ausbildende Metalllage (19, 29) auf der dem Kühlelement (3) gegenüberliegenden Oberfläche des Isoliersubstrats (10, 20) angebracht ist, und dass die Metalllage (19, 29) derart strukturiert ist, dass die von der Metalllage gebildeten Metallisierungsflächen (12, 13, 22, 23), die mit den ein oder mehreren Leistungselektronikbauelementen (15, 25) verbunden sind, von dem die Metallkrempe (11, 21) bildenden Bereich der Metalllage (19, 29) elektrisch isoliert sind.

5. Leistungselektronikanordnung nach einem der vorgehenden Ansprüche, **dadurch gekennzeichnet,**
**dass** das Isoliersubstrat (20) auf seiner dem Kühlelement (3) zugewandten Seite zur Verringerung des thermischen Widerstandes zum Kühlmedium (4) strukturiert ist.

6. Leistungselektronikanordnung (1, 2) nach Anspruch 2,
**dadurch gekennzeichnet,**
**dass** der Klemmrahmen (6) mit dem Kühlelement (3) mittels zwei oder mehr Spannschrauben (51, 52) verbunden ist.

7. Leistungselektronikanordnung (1, 2) nach Anspruch 2,
**dadurch gekennzeichnet,**
**dass** der umlaufende Klemmrahmen (6) das Isoliersubstrat (10, 20) überlappt.

8. Leistungselektronikanordnung nach Anspruch 2,
**dadurch gekennzeichnet,**
**dass** der Klemmrahmen (6) mit einem oder mehreren Stegen versehen ist.

9. Leistungselektronikanordnung nach einem der vorgehenden Ansprüche, **dadurch gekennzeichnet,**
**dass** das Kühlelement (3) einen oder mehrere Abstandshalter zur Auflage des Isoliersubstrats aufweist.

10. Leistungselektronikanordnung nach einem der vorgehenden Ansprüche, **dadurch gekennzeichnet,**
**dass** die Metallkrempe (21) einen Faltenbalg oder eine Sicke (71) aufweist.

11. Leistungselektronikanordnung (2) nach Anspruch 2,
**dadurch gekennzeichnet,**
**dass** der Klemmrahmen (6) und/oder das Kühlelement (3) im Bereich der Dichtflächen (63, 33) eine oder mehrere Dichtschneiden (64, 34) aufweist.

12. Leistungselektronikanordnung (1, 2) nach einem der vorgehenden Ansprüche,
**dadurch gekennzeichnet,**
**dass** die die Metallkrempe (11, 21) ausbildende Metallage (19, 29) aus Kupfer, einer Kupferlegierung, Aluminium oder einer Aluminiumlegierung besteht.

## Claims

1. Power electronics assembly (1, 2) having an insulating substrate (10, 20), which is provided with one or more metallisation surfaces (12, 13; 22, 23), having a cooling element (3) arranged below the insulating substrate (10, 20) and having one or more power electronic components (15, 25) which are applied to respective metallisation surfaces (12, 22) on a side of the insulating substrate (10, 20) opposite the cooling element (3),
wherein a metal layer (19, 29) is applied to the surface of the insulating substrate (10, 20) lying opposite the cooling element or facing towards the cooling element, said metal layer (19, 29) projecting beyond the insulating substrate (10, 20) on all sides, wherein the region of the metal layer (19, 29) projecting beyond the insulating substrate (10, 20) forms a metal rim (11, 21) which borders the insulating substrate (10, 20), the cooling element (3) has one or more recesses on its side facing towards the insulating substrate (10, 20) below the insulating substrate (10, 20) and a cavity (35), below the insulating substrate (10, 20), which is delimited by the insulating substrate (10, 20) and by wall surfaces of the one or more recesses for receiving a liquid cooling medium (4) and the metal rim (11, 21) is connected to the cooling element (3),
**characterised in that**
- the metal layer (19, 29) is 0.1-2mm thick,
- the insulating substrate (10, 20) is a ceramic substrate and
- the metal layer (19, 29) is actively soldered onto the insulating substrate (10, 20).

2. Power electronics assembly according to claim 1,
**characterised in that** the power electronics assembly (1, 2) has a peripheral clamp frame (6) which overlaps the metal rim (11, 21), and the metal rim (11, 21) is clamped between the clamp frame (6) and the cooling element (3) and is thus connected to the cooling element (3).

3. Power electronics assembly according to claim 1,
**characterised in that** the metal rim (11, 21) is integrally connected to the cooling element (3), in particular by welding or soldering.

4. Power electronics assembly (1, 2) according to one of the preceding claims,
**characterised in that** the metal layer (19, 29) forming the metal rim (11, 21) is applied to the surface of the insulating substrate (10, 20) which is opposite the cooling element (3), and the metal layer (19, 29) is structured in such a way that the metallisation surfaces (12, 13, 22, 23) formed by the metal layer, which are connected to the one or more power electronics components (15, 25), are electrically insulated from the region of the metal layer (19, 29) forming the metal rim (11,21).

5. Power electronics assembly according to one of the preceding claims,
**characterised in that** the insulating substrate (20) is structured on its side facing towards the cooling element (3) to reduce the thermal resistance to the cooling medium (4).

6. Power electronics assembly (1, 2) according to claim 2,
**characterised in that** the clamp frame (6) is connected to the cooling element (3) by means of two or more clamping screws (51, 52).

7. Power electronics assembly (1, 2) according to claim 2,
**characterised in that** the peripheral clamp frame (6) overlaps the insulating substrate (10, 20).

8. Power electronics assembly according to claim 2,
**characterised in that** the clamp frame (6) is provided with one or more webs.

9. Power electronics assembly according to one of the preceding claims,
**characterised in that** the cooling element (3) has one or more spacers for supporting the insulating substrate.

10. Power electronics assembly according to one of the preceding claims,
**characterised in that** the metal rim (21) has a bellows or a bead (71).

11. Power electronics assembly (2) according to claim 2,
**characterised in that** the clamp frame (6) and/or the cooling element (3) has one or more sealing edges (64, 34) in the region of the sealing surfaces (63, 33).

12. Power electronics assembly (1,2) according to one of the preceding claims,
**characterised in that** the metal layer (19, 29) forming the metal rim (11, 21) consists of copper, a copper alloy, aluminium or an aluminium alloy.

## Revendications

1. Ensemble électronique de puissance (1, 2) comprenant un substrat isolant (10, 20), qui est pourvu d'une ou de plusieurs faces de métallisation (12, 13 ; 22, 23), comprenant un élément de refroidissement (3) disposé sous le substrat isolant (10, 20) et un ou plusieurs composants électroniques de puissance (15, 25), qui sont installés sur un côté du substrat isolant (10, 20) par rapport à l'élément de refroidissement (3) sur des faces de métallisation (12, 22) respectives,
dans lequel
une couche de métal (19, 29) est installée sur la surface, opposée à l'élément de refroidissement ou tournée vers l'élément de refroidissement, du substrat isolant (10, 20), laquelle dépasse de tous les côtés du substrat isolant (10, 20),
dans lequel la zone, dépassant le substrat isolant (10, 20), de la couche de métal (19, 29) réalise un bord en métal (11, 21) encadrant le substrat isolant (10, 20), l'élément de refroidissement (3) présente, sur son côté tourné vers le substrat isolant (10, 20), sous le substrat isolant (10, 20), un ou plusieurs évidements et un espace creux (35) délimité par le substrat isolant (10, 20) et par des faces de paroi d'un ou de plusieurs évidements est réalisé sous le substrat isolant (10, 20) afin de recevoir un milieu de refroidissement (4) liquide, et le bord en métal (11, 21) est relié à l'élément de refroidissement (3), **caractérisé en ce que**
- la couche de métal (19, 29) présente une épaisseur de 0,1 - 2 mm,
- le substrat isolant (10, 20) est un substrat en céramique, et
- la couche de métal (19, 29) sur le substrat isolant (10, 20) est soumise à un brasage actif.

2. Ensemble électronique de puissance selon la revendication 1,
**caractérisé en ce**
**que** l'ensemble électronique de puissance (1, 2) présente un cadre de serrage (6) périphérique chevauchant le bord en métal (11, 21), et
**que** le bord en métal (11, 21) est enserré entre le cadre de serrage (6) et l'élément de refroidissement (3) et est ainsi relié à l'élément de refroidissement (3).

3. Ensemble électronique de puissance selon la revendication 1,
**caractérisé en ce**
**que** le bord en métal (11, 21) est relié par liaison de matière, en particulier par soudage ou brasage, à l'élément de refroidissement (3).

4. Ensemble électronique de puissance (1, 2) selon l'une quelconque des revendications précédentes,
**caractérisé en ce**
**que** la couche de métal (19, 29) réalisant le bord en métal (11, 21) est installée sur la surface, opposée à l'élément de refroidissement (3), du substrat isolant (10, 20), et que la couche de métal (19, 29) est structurée de telle manière que les faces de métallisation (12, 13, 22, 23) formées par la couche de métal, qui sont reliées à un ou à plusieurs composants électroniques de puissance (15, 25), sont isolées électriquement de la zone, formant le bord en métal (11, 21), de la couche de métal (19, 29).

5. Ensemble électronique de puissance selon l'une quelconque des revendications précédentes,
**caractérisé en ce**
**que** le substrat isolant (20) est structuré sur son côté, tourné vers l'élément de refroidissement (3), afin de réduire la résistance thermique par rapport au milieu de refroidissement (4).

6. Ensemble électronique de puissance (1, 2) selon la revendication 2,
**caractérisé en ce**
**que** le cadre de serrage (6) est relié à l'élément de serrage (3) au moyen de deux vis de serrage (51, 52) ou plus.

7. Ensemble électronique de puissance (1, 2) selon la revendication 2,
**caractérisé en ce**
**que** le cadre de serrage (6) périphérique chevauche le substrat isolant (10, 20).

8. Ensemble électronique de puissance selon la revendication 2,
**caractérisé en ce**
**que** le cadre de serrage (6) est pourvu d'une ou de plusieurs entretoises.

9. Ensemble électronique de puissance selon l'une quelconque des revendications précédentes,
**caractérisé en ce**
**que** l'élément de refroidissement (3) présente un ou plusieurs écarteurs servant à supporter le substrat isolant.

10. Ensemble électronique de puissance selon l'une quelconque des revendications précédentes,
**caractérisé en ce**
**que** le bord en métal (21) présente un soufflet ou une moulure (71).

11. Ensemble électronique de puissance (2) selon la revendication 2,
**caractérisé en ce**
**que** le cadre de serrage (6) et/ou l'élément de serrage (3) présentent dans la zone des faces étanches (63, 33) un ou plusieurs tranchants étanches (64, 34).

12. Ensemble électronique de puissance (1, 2) selon l'une quelconque des revendications précédentes,
**caractérisé en ce**
**que** la couche de métal (19, 29) réalisant le bord en métal (11, 21) est constituée de cuivre, d'un alliage en cuivre, d'aluminium ou d'un alliage en aluminium.
